# EUROPEAN PATENT SPECIFICATION

(11) **EP 2 225 827 B1**
(45) Date of publication and mention of the grant of the patent: **01.05.2013**
(21) Application number: 08858823.1
(22) Date of filing: 08.12.2008
(51) Int. Cl.: H03G 7/00

(54) **PREVENTION OF AUDIO SIGNAL CLIPPING**
CLIPPING-VERHINDERUNG FÜR AUDIOSIGNALE
PRÉVENTION D'ÉCRÊTAGE DE SIGNAL AUDIO

(30) Priority: 11.12.2007 EP 07122924
(43) Date of publication of application: 08.09.2010
(73) Proprietor: NXP B.V., 5656 AG Eindhoven (NL)
(72) Inventor: HUIJNEN, Anton, Leonard, Redhill Surrey RH1 1DL (GB); VOGEL, Durk, Pieter, Redhill Surrey RH1 1DL (GB)
(74) Representative: Schouten, Marcus Maria
(86) International application number: PCT/IB2008/055145
(87) International publication number: WO 2009/074945

(56) References cited:
- WO-A-2006/106479
- GB-A- 2 001 495
- GB-A- 2 407 012
- US-A1- 2002 090 096
- US-A1- 2006 147 049
- US-B1- 7 013 011

## Description

The invention relates to a method and apparatus for preventing the unwanted clipping of an audio signal.

Audio signals can typically vary in amplitude up to a maximum permitted level. For example, if the audio signal is digitally coded, then the maximum amplitude level that can be represented may be limited by the numerical limits of the digital coding. If the audio signal is an analogue voltage signal, then the maximum amplitude level may be limited by the maximum voltage that a particular analogue circuit component handling the signal can support.

If an audio signal is amplified beyond this maximum amplitude level, as can occur when large amplification factors are combined with large input signal values, then the amplitude of the signal will be "clipped" to this maximum amplitude level. Clipping can occur at many different processing stages of an audio system, for example, it can occur when converting the audio signal between Analogue and Digital representations, or when converting the audio signal between the Time Domain and the Frequency Domain.

Clipping of an audio signal can lead to large, unwanted distortions. For example, if an audio signal comprises a low frequency component having a high amplitude and a high frequency component having a low amplitude, then clipping the audio signal to an amplitude lower than the amplitude of the low-frequency component, is likely to result in the loss of the high frequency signal at the peaks and the troughs of the audio signal waveform, and is likely to introduce harmonic distortion.

To avoid clipping in an audio signal amplifier, a detector can be used to detect clipping, and then signal processing techniques can be used to reduce the audio signal amplitude to prevent the clipping from occurring. However, the reduction of the audio signal amplitude can lead to unwanted audio artefacts, such as 'pumping' in the average audio signal amplitude. This can occur when the audio signal amplitude is reduced to avoid clipping for a few seconds, and then later restored once the danger of clipping has passed.

US Patent 5,737,432 discloses a split-band clipper for reducing "low to high" frequency distortion during clipping. The split-band clipper splits the audio signal into a higher frequency band signal and a lower frequency band signal, and clips the lower frequency band signal using a variable level clipper. The clipped lower frequency band signal is then summed with the higher frequency band signal, and the summed signal is clipped by a fixed level clipper at the output.

If the fixed level clipper results in clipping of the high frequency band part of the summed signal, then the variable level clipper is varied to clip the low frequency band signals at a lower clip level. Therefore, low-to-high frequency distortion is reduced. However, distortion still occurs within the lower frequency band, and is particularly severe if high amplitude signals are present within the higher frequency band. This is because the lower frequency band will be heavily clipped at the variable level clipper, in order to prevent clipping of the high frequency band part of the summed signal at the fixed level clipper.

WO 2006/106479 (Koninklijke Philips Electronics N.V.) discloses a method of and a device for processing audio data, wherein the device comprises a mid-frequency filter unit adapted to selectively filter omit-frequency range component of the audio data.

GB 2001495 (Orban Associates Inc.) discloses a peak-limiting apparatus and method particularly useful in system employing high frequency pre-emphasis to compensate for steep high frequency roll off in a receiver, or the like.

US 7 013 011 (Weeks et al) discloses an audio limiting circuit capable of satisfying frequency dependent limits and time domain constraints.

GB 2407012 (Motorola Inc.) discloses a speech communication unit and method of level adjustment therein.

US 2006/0147049 (Bailey et al) discloses a sound pressure level limited with anti-startle feature.

US 2002/0090096 (Blind et al) discloses an audio amplifier with voltage limiting in response to spectral content

It is, therefore, an object of the invention to improve on the known art.

According to a first aspect of the invention, there is provided a method for preventing clipping of an audio signal, comprising:
- determining the highest amplitude frequency components of the audio signal in the frequency domain; and
- reducing the amplitudes of the highest amplitude frequency components until a level of clipping of the audio signal falls below a predetermined level.
Since the highest amplitude frequency components in the frequency domain contribute the most to the overall amplitude of the audio signal in the time domain, these frequency components also contribute the most to any clipping that may occur. These frequency components can be identified in the frequency domain, and then the amplitudes of these particular frequency components can be reduced until a level of clipping of the audio signal falls below a predetermined level. The predetermined level is typically set according to the maximum level of clipping that is to be tolerated in the system.

The reduction of the particular frequency components that contribute most towards clipping greatly reduces distortion, without having to reduce the amplitudes of all frequencies of the audio signal.

Advantageously, the audio signal may be received in the time domain, and then transformed into the frequency domain for the determination of the highest-amplitude frequency components. The result of the determination can be used to reduce the amplitudes of the highest frequency components when the audio signal is in the frequency domain, or when the audio signal is in the time domain.

The level of clipping may be determined according to one or more clip predictors or clip detectors at various locations within the system. For example, a clip predictor may detect the amplitude of the audio signal. Then, given knowledge of the subsequent audio signal path (for example, amplification factors and signal headroom), the clip predictor may predict a level of clipping that is likely to result.

A clip detector may detect a level of clipping of the audio signal by measuring how often the audio signal reaches or exceeds the maximum allowed amplitude. For example, if an audio signal often reaches or exceeds the maximum allowed amplitude, causing distortion, then it is said to have a high level of clipping. The clip detector may detect a level of clipping immediately after the step of reducing, or the clip detector may detect a level of clipping after the audio signal has been reduced and amplified. The clipping prediction and/or detection typically takes place when the audio signal is in the time domain.

The level of reduction of the highest amplitude frequency components may be weighted (set) according to each frequency components amplitude and frequency. Very high amplitude frequency components may be reduced by more than less high amplitude frequency components. Frequency components falling within voice bands, such as 200 - 3600 Hz, may be reduced by less than other frequency components for voice applications. Alternatively, high frequency components may be reduced more than low frequency components, because clipping of low-frequency components can be less annoying than clipping of high-frequency components for music.

According to a second aspect of the invention, there is provided a circuit for preventing clipping of an audio signal, the circuit comprising:
- a determining means adapted to determine the highest amplitude frequency components of the audio signal in the frequency domain; and
- a reducing means adapted to reduce the amplitudes of the highest amplitude frequency components until a level of clipping of the audio signal falls below a predetermined level.

The circuit's determining means and reducing means may be formed entirely of hardware, or by a combination of hardware and software. For example, a digital signal processor or an audio apparatus, such as a computer sound card or a Hi-Fi system, may be configured by software to implement the determining means and the reducing means. The software is typically stored on a carrier, such as an optical disk, or a RAM or ROM memory.

Embodiments of the invention will now be described, with reference to the accompanying drawings, in which:
Fig. 1 shows a flow diagram of a method for preventing clipping of an audio signal according to a first embodiment of the invention;
Fig. 2 shows a block diagram of a circuit for preventing clipping of an audio signal according to the first embodiment of the invention;
Fig. 3 shows a block diagram of a circuit for preventing clipping of an audio signal according to a second embodiment of the invention; and
Fig. 4 shows a block diagram of a circuit for preventing clipping of an audio signal according to a third embodiment of the invention.

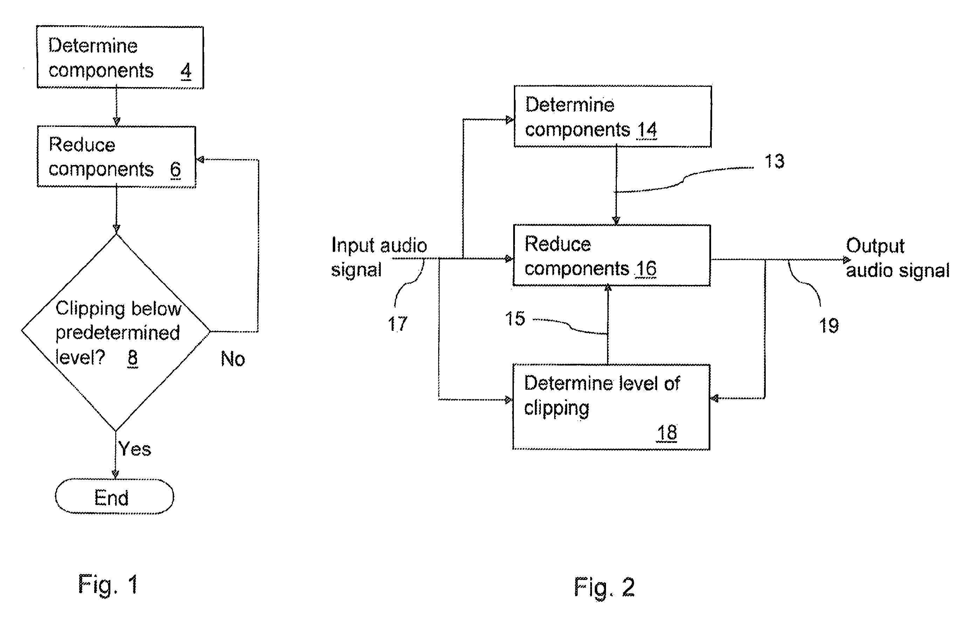

A first embodiment of the invention will now be described with reference to Fig. 1 and Fig. 2. The flow diagram of Fig. 1 begins at step 4 where the highest amplitude frequency components of the audio signal are measured in the frequency domain. Next, at steps 6 and 8, the amplitudes of the highest amplitude frequency components are reduced until the level of clipping of the audio signal falls below a predetermined level.

Fig. 2 shows a block diagram of a circuit for implementing the flow diagram of Fig. 1. The circuit comprises a block 14 for determining the highest amplitude frequency components; a block 16 for reducing the amplitudes of the highest amplitude frequency components, and a block 18 for determining the level of clipping of the audio signal.

In use, the input audio signal 17 is sent to the blocks 14, 16, and 18. The block 14 transforms the input audio signal 17 into the Frequency Domain, and then determines the highest amplitude frequency components. The block 14 also sends a signal 13 to the block 16, the signal 13 indicating which frequency components were determined as having the highest amplitudes.

The block 18 determines the level of clipping of the output audio signal 19 according to a level of clipping that is predicted to occur given the input audio signal 17, and according to a level of clipping that is detected in the output audio signal 19. The predicted level of clipping is predicted by measuring the amplitude of the input audio signal 17, and determining whether clipping will occur given information on the subsequent processing (e.g. amplification, analogue or digital conversion) stages in the system. The detected level of clipping is detected by measuring how often the amplitude of the output audio signal 19 meets or exceeds the maximum allowed amplitude. The maximum allowed amplitude is, for example, the maximum amplitude that can be represented by the digital coding if the output signal 19 is digital, or the maximum voltage that can be supported by the circuitry if the output signal 19 is analogue. The block 18 sends the determined level of clipping to block 16 via signal 15.

The block 16 reduces the amplitudes of the highest amplitude frequency components of the input audio signal 17, according to a comparison between the level of clipping indicated by the signal 15, and a predetermined level of clipping. The predetermined level of clipping is the maximum level of clipping that is to be tolerated in the system, i.e. the limit on how often the audio signal is permitted to reach or exceed the maximum allowed amplitude. If the level of clipping of the audio signal indicated by signal 15 is above the predetermined level of clipping, then the block 16 reduces the amplitudes of the frequency components that are indicated by signal 13, until the signal 15 indicates that the level of clipping of the audio signal has fallen below the predetermined level. The circuit blocks 14, 16, and 18 are formed by a digital signal processor, i.e. by hardware that is programmed by software.

In the first embodiment, the level of clipping of the audio signal is determined according to both a predicted level of clipping, and according to a detected level of clipping. Alternatively, the level of clipping of the audio signal may be determined only from a predicted level of clipping, or only from a detected level of clipping. It can be useful to use both a predicted level of clipping and a detected level of clipping when there is insufficient information on the audio signal path to accurately predict the level of clipping of the audio signal.

In the first embodiment, the input audio signal 17 is in the time domain, and the block 14 converts the audio signal into the frequency domain, in order to determine the highest amplitude frequency components. The conversion into the frequency domain is performed using a technique such as the well-known Fast Fourier Transform (FFT), as will be apparent to those skilled in the art. The block 16 receives the audio signal 17 in the time domain, and reduces the amplitudes of the frequency components indicated by signal 13 in the time domain, in order to give the output audio signal 19.

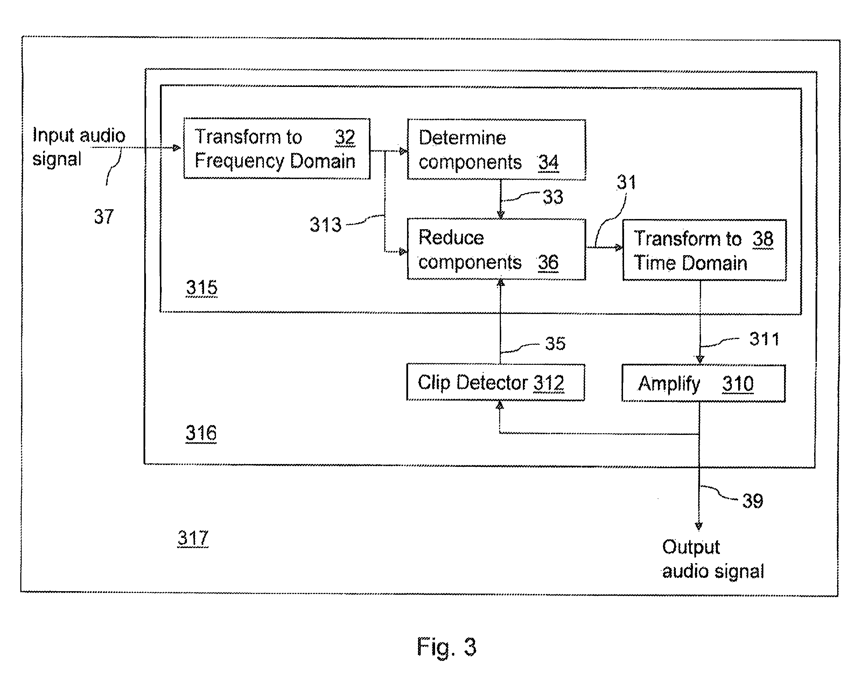

A second embodiment of the invention will now be described with reference to Fig. 3. Fig. 3 shows a block diagram of a computer 317 comprising a sound card 316 that receives a digital input audio signal 37 in the time domain and outputs an amplified analogue audio signal 39. The sound card 316 has been programmed by a computer program to form blocks 32, 34, 36, 38, 310, and 312, of which blocks 32, 34, 36, and 38 are implemented within a digital signal processor 315. The computer program software is stored on a carrier such as an optically readable disk or a hard disk of the computer.

The input audio signal 37 is first transformed into the frequency domain by block 32 to give an audio signal 313, and then block 34 determines the highest amplitude frequency components of the audio signal 313, and outputs this information as a signal 33 to block 36. The block 36 also receives the audio signal 313, and reduces the amplitudes of the frequency components indicated by signal 33 in the frequency domain, in order to give an audio signal 31.

The audio signal 31 is transformed from the frequency domain into the time domain by a block 38, using a technique such as the well-known Inverse Fast Fourier Transform (IFFT), to give an audio signal 311. The audio signal 311 is then amplified by block 310 to give output audio signal 39. A clip detector (block 312) detects how often the amplitude of the output audio signal 39 reaches or exceeds the maximum allowed amplitude, in order to detect a level of clipping of the audio signal 39. The clip detector 312 sends a signal 35 to the block 36 to indicate the detected level of clipping. If the detected level of clipping is above a predetermined maximum allowable level of clipping, then the block 36 reduces the highest amplitude frequency components of the audio signal until the level of clipping detected by the clip detector 312 falls below the predetermined level.

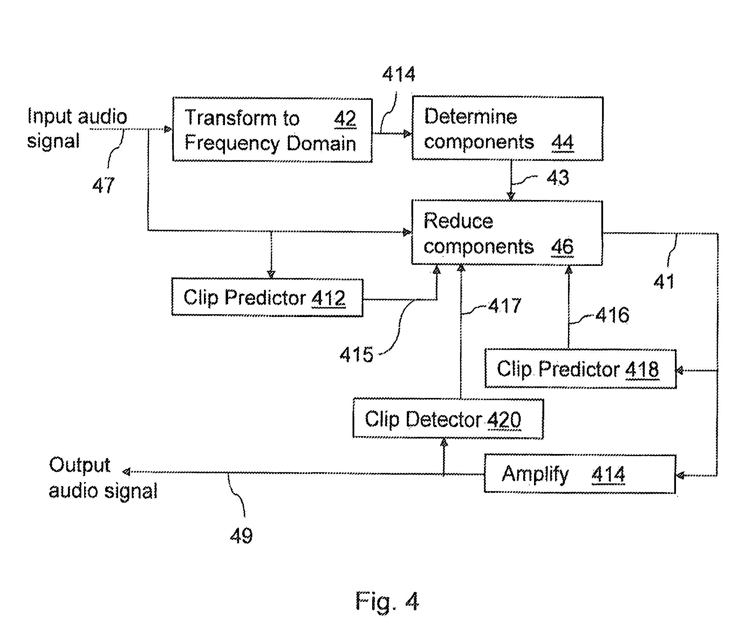

A third embodiment of the invention will now be described with reference to Fig. 4, which shows a block diagram of a circuit receiving an analogue input audio signal 47. The block 42 converts the input audio signal 47 into a digital audio signal, and transforms the digital audio signal into the frequency domain to give an audio signal 414. The audio signal 414 is passed to block 44, which determines the highest amplitude frequency components in the frequency domain by measuring the amplitudes of each of the frequency components, and ordering them accordingly. Block 44 sends a signal 43 to block 46, the signal 43 indicating the frequency components of audio signal 47 in order of amplitude.

The block 46 receives the signal 43 and the analogue audio signal 47. Block 46 uses the amplitude ordering information of signal 43 to firstly reduce the highest amplitude frequency component of audio signal 47, then reduce both the first and second highest amplitude frequency components, and then reduce the first, second, and third highest amplitude frequency components, and so on until the level of clipping of the audio signal (as indicated by signals 415, 416, and 417 discussed below) falls below a predetermined level. For example, if the signal 43 indicates that:
- the highest amplitude frequency component is -5dB at 100Hz;
- the second highest amplitude frequency component is -7dB at 150Hz;
- the third highest amplitude frequency component is -10dB at 50Hz;
then block 46 will first reduce the 100Hz frequency component to -7dB (the same as the amplitude of the second highest amplitude frequency component), then reduce both the 100Hz and 150Hz frequency components to -10dB (the same as the amplitude of the third highest amplitude frequency component), and then reduce the 50Hz, 100Hz, and 150Hz frequency components down to the same amplitude as the fourth highest amplitude frequency component, and so on until the level of clipping of the audio signal falls below the predetermined level.

Those skilled in the art will appreciate that a frequency component of 100Hz will typically encompass a range of frequencies, for example from 75Hz to 125Hz, depending on the resolution of the determination performed in the frequency domain by block 44.

Many other methods of reducing the frequency components will be apparent to those skilled in the art. For example, the highest amplitude frequency component may be reduced until it is within 1dB of the second highest amplitude frequency component (instead of being reduced until it is the same amplitude as the second highest amplitude frequency component), and then both the highest and second highest amplitude frequency components may be reduced until the second highest amplitude frequency component is within 1dB of the third highest amplitude frequency component (instead of both the highest and second highest amplitude frequency components being reduced until they are both the same amplitude as the third highest amplitude frequency component), and so on.

The block 46 reduces frequency components according to their amplitudes, although it may alternatively reduce frequency components according to both their amplitudes and frequencies. For example, in voice applications, frequency components within a voice band of 200 - 3600Hz may be reduced by a lower amount than frequency components outside of this voice band. One way of achieving this would be to reduce a frequency component until it is within 2dB of the next highest frequency component if the reduced frequency component is between 200 - 3600Hz, and by reducing a frequency component until it is within 1 dB of the next highest frequency component if the reduced frequency component is outside of 200 - 3600Hz.

The frequency components are reduced by filtering them out from the audio signal 47, and the degree of filtering is increased when the level of clipping is above the predetermined level, and decreased when the level of clipping has remained below the predetermined level for a certain period of time, for example 30 seconds.

The audio signal 41 is amplified by block 414 to give an output audio signal 49.

A clip predictor block 412 receives the input audio signal 47, and predicts a level of clipping that may occur within the audio signal 41 based on the amplitude of the input audio signal 47 in comparison to a predetermined amplitude. The predetermined amplitude is the maximum audio signal amplitude that can be handled by the block 46 before block 46 causes clipping of the audio signal 41. If the clip predictor block 412 determines that the amplitude of the input audio signal 47 regularly rises above the predetermined amplitude, then the clip predictor block 412 predicts that block 46 will cause clipping of the audio signal 41, and communicates this to block 46 via the signal 415. If the clip predictor block 412 determines that the amplitude of the input audio signal 47 rarely or never rises above the predetermined amplitude, then it predicts that clipping is unlikely to occur in block 46, and communicates this to block 46 via signal 415.

A further clip predictor block 418 receives the audio signal 41 and predicts a level of clipping that may occur within the output audio signal 49, based on the amplitude of the audio signal 41 and on the level of amplification applied in the block 414. The predicted level of clipping is sent to block 46 via the signal 416.

In the third embodiment, the signals 415 and 416 either indicate that a high level of clipping is predicted, or that a low level of clipping is predicted. Alternatively, the signals 415 and 416 may give more accurate information on the level of clipping, for example they may indicate the predicted level of clipping on a scale from 1 to 10, according to how often the clip predictors predict that the audio signals will reach or exceed the maximum allowed amplitudes.

A clip detector block 420 detects how often the amplitude of the output audio signal 49 reaches or exceeds the maximum allowed amplitude, in order to detect a level of clipping of the audio signal 49. The clip detector block 420 sends a signal 417 to the block 46 to indicate the detected level of clipping.

The block 46 reduces the amplitudes of the highest amplitude audio components until the levels of clipping indicated by signals 415, 416, and 417 all fall below the predetermined level of clipping. Alternatively, the block 46 may add the levels of clipping indicated by signals 415, 416, and 417 together to give an overall level of clipping, and reduce the amplitudes of the highest amplitude audio components until this overall level of clipping falls below the predetermined level of clipping. The three clip predictor/detector blocks 412, 418 and 420 help provide an accurate representation of any clipping that occurs in the system via signals 415, 416 and 417 respectively. Alternatively, only one or two of the clip predictor/detector blocks may be implemented to save on the complexity of the circuit, whilst still providing at least one signal for the block 46 to use when reducing the amplitudes of the highest amplitude audio components.

It will be apparent to those skilled in the art that many other signal processing blocks could optionally be arranged amongst or around the blocks described herein, to implement other signal processing functions. For example, clip predictor/detector blocks coupled to blocks that determine and reduce the highest amplitude frequency components could be introduced into a wide variety of known audio systems to prevent clipping of an audio signal.

From reading the present disclosure, other variations and modifications will be apparent to the skilled person. Such variations and modifications may involve equivalent and other features which are already known in the art, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The same description is not repeated where it is clear that the description relating to one embodiment is also equally applicable to the other embodiments. For example, the blocks 14, 34, and 44 all perform the function of determining frequency components, and therefore specific features described in relation to one of these blocks can easily be applied to the others of these blocks. The same applies to blocks 16, 36, and 46, which all perform the function of reducing frequency components.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A method for preventing clipping of an audio signal, comprising:
- determining the highest amplitude frequency components of the audio signal in the frequency domain;
- determining a first level of clipping according to a level of clipping predicted from the amplitude of the audio signal;
- reducing the amplitudes of the highest amplitude frequency components;
- determining a second level of clipping according to a level of clipping predicted in the audio signal after the step of reducing; and
wherein reducing the amplitudes of the highest amplitude frequency components is performed until the first and second levels of clipping fall below a predetermined level.

2. The method of claim 1, further comprising:
- determining a third level of clipping according to a level of clipping detected in the audio signal after amplification of the audio signal after the step of reducing, and
wherein reducing the amplitudes of the highest amplitude frequency components is performed until the first, second and third levels of clipping fall below a predetermined level.

3. The method of claim 1 or claim 2, further comprising receiving the audio signal in the time domain, and transforming the audio signal into the frequency domain before the step of determining.

4. The method of any one of claims 1 to 3, wherein the step of reducing takes place when the audio signal is in the time domain.

5. The method of any one of claims 1 to 3, wherein the step of reducing takes place when the audio signal is in the frequency domain.

6. The method of any preceding claim, wherein the step of reducing comprises setting the amount of reduction of each determined frequency component according to at least one of the amplitude and frequency of the determined frequency component.

7. A circuit for preventing clipping of an audio signal, the circuit comprising:
- a determining means adapted to determine the highest amplitude frequency components of the audio signal in the frequency domain;
- a determining means configured to determine a first level of clipping predicted from the amplitude of the audio signal;
- a reducing means adapted to reduce the amplitudes of the highest amplitude frequency components;
- a determining means configured to determine a second level of clipping according to a level of clipping predicted in the audio signal after being processed by the reducing means;
wherein the reducing means is configured to reduce the amplitudes of the highest amplitude frequency components until the first and second levels of clipping fall below a predetermined level.

8. A digital signal processor comprising the circuit of claim 7.

9. An audio apparatus comprising the circuit of claim 7.

10. Software for configuring hardware to form the circuit of claim 7.

## Patentansprüche

1. Ein Verfahren zum Verhindern eines Abschneidens eines Audiosignals, welches aufweist:
- Bestimmen der Höchste-Amplitude Frequenzkomponenten des Audiosignals in der Frequenzdomäne,
- Bestimmen einer ersten Stufe des Abschneidens gemäß einer Stufe des Abschneidens, welche aus der Amplitude des Audiosignals vorhergesagt wird,
- Reduzieren der Amplituden der Höchste-Amplitude Frequenzkomponenten,
- Bestimmen einer zweiten Stufe des Abschneidens gemäß einer Stufe des Abschneidens, welche in dem Audiosignal nach dem Schritt des Reduzierens vorhergesagt wird, und
wobei das Reduzieren der Amplituden der Höchste-Amplitude Frequenzkomponenten durchgeführt wird, bis die erste und zweite Stufe des Abschneidens unter eine vorgegebene Stufe fallen.

2. Das Verfahren gemäß Anspruch 1, welches ferner aufweist:
- Bestimmen einer dritten Stufe des Abschneidens gemäß einer Stufe des Abschneidens, welche in dem Audiosignal nach einer Verstärkung des Audiosignals nach dem Schritt des Reduzierens detektiert wird, und
wobei das Reduzieren der Amplituden der Höchste-Amplitude Frequenzkomponenten durchgeführt wird, bis die erste, zweite und dritte Stufe des Abschneidens unter eine vorgegebene Stufe fallen.

3. Das Verfahren gemäß Anspruch 1 oder Anspruch 2, welches ferner ein Empfangen des Audiosignals in der Zeitdomäne und ein Transformieren des Audiosignals in die Frequenzdomäne vor dem Schritt des Bestimmens aufweist.

4. Das Verfahren gemäß irgendeinem der Ansprüche 1 bis 3, wobei der Schritt des Reduzierens stattfindet, wenn das Audiosignal in der Zeitdomäne ist.

5. Das Verfahren gemäß irgendeinem der Ansprüche 1 bis 3, wobei der Schritt des Reduzierens stattfindet, wenn das Audiosignal in der Frequenzdomäne ist.

6. Das Verfahren gemäß irgendeinem vorherigen Anspruch, wobei der Schritt des Reduzierens ein Setzen des Umfangs der Reduktion von jeder bestimmten Frequenzkomponente gemäß zumindest eines aus der Amplitude und der Frequenz der bestimmten Frequenzkomponente aufweist.

7. Ein Schaltkreis zum Verhindern eines Abschneidens eines Audiosignals, wobei der Schaltkreis aufweist:
- ein Bestimmungsmittel, welches angepasst ist, die Höchste-Amplitude Frequenzkomponenten des Audiosignals in der Frequenzdomäne zu bestimmen,
- ein Bestimmungsmittel, welches konfiguriert ist, eine erste Stufe des Abschneidens zu bestimmen, welche aus der Amplitude des Audiosignals vorhergesagt ist,
- ein Reduziermittel, welches angepasst ist, die Amplituden der Höchste-Amplitude Frequenzkomponenten zu reduzieren,
- ein Bestimmungsmittel, welches konfiguriert ist, eine zweite Stufe des Abschneidens gemäß einer Stufe des Abschneidens zu bestimmen, welche nach einem Verarbeitet werden mittels des Reduziermittels in dem Audiosignal vorhergesagt ist,
wobei das Reduziermittel konfiguriert ist, die Amplituden der Höchste-Amplitude Frequenzkomponenten zu reduzieren, bis die erste und zweite Stufe des Abschneidens unter eine vorgegebene Stufe fallen.

8. Einen digitalen Signalprozessor, welcher den Schaltkreis gemäß Anspruch 7 aufweist.

9. Eine Audiovorrichtung, welche den Schaltkreis gemäß Anspruch 7 aufweist.

10. Software zum Konfigurieren von Hardware, um den Schaltkreis gemäß Anspruch 7 zu bilden.

## Revendications

1. Procédé pour la prévention de l'écrêtage d'un signal audio, comprenant :
- une détermination des composantes de fréquence ayant la plus grande amplitude du signal audio dans le domaine fréquentiel ;
- une détermination d'un premier niveau d'écrêtage en fonction d'un niveau d'écrêtage prédit à partir de l'amplitude du signal audio ;
- une réduction des amplitudes des composantes de fréquence ayant la plus grande amplitude ;
- une détermination d'un deuxième niveau d'écrêtage en fonction d'un niveau d'écrêtage prédit dans le signal audio après l'étape de réduction ; et
dans lequel la réduction des amplitudes des composantes de fréquence ayant la plus grande amplitude est mise en oeuvre jusqu'à ce que les premier et deuxième niveaux d'écrêtage s'abaissent au-dessous d'un niveau prédéterminé.

2. Procédé selon la revendication 1, comprenant en outre :
- une détermination d'un troisième niveau d'écrêtage en fonction d'un niveau d'écrêtage détecté dans le signal audio après une amplification du signal audio effectuée après l'étape de réduction ; et
dans lequel la réduction des amplitudes des composantes de fréquence ayant la plus grande amplitude est mise en oeuvre jusqu'à ce que les premier, deuxième et troisième niveaux d'écrêtage s'abaissent au-dessous d'un niveau prédéterminé.

3. Procédé selon la revendication 1 ou la revendication 2, comprenant en outre une réception du signal audio dans le domaine temporel, et une transformation du signal audio dans le domaine fréquentiel avant l'étape de détermination.

4. Procédé selon l'une quelconque des revendications 1 à 3, dans lequel l'étape de réduction prend place lorsque le signal audio est dans le domaine temporel.

5. Procédé selon l'une quelconque des revendications 1 à 3, dans lequel l'étape de réduction prend place lorsque le signal audio est dans le domaine fréquentiel.

6. Procédé selon une quelconque revendication précédente, dans lequel l'étape de réduction comprend un réglage de l'importance de la réduction de chaque composante de fréquence déterminée, en fonction d'au moins l'une parmi l'amplitude et la fréquence de la composante de fréquence déterminée.

7. Circuit pour la prévention de l'écrêtage d'un signal audio, le circuit comprenant :
- des moyens de détermination aptes à déterminer les composantes de fréquence ayant la plus grande amplitude du signal audio dans le domaine fréquentiel ;
- des moyens de détermination configurés pour déterminer un premier niveau d'écrêtage prédit à partir de l'amplitude du signal audio ;
- des moyens de réduction aptes à réduire les amplitudes des composantes de fréquence ayant la plus grande amplitude ;
- des moyens de détermination configurés pour déterminer un deuxième niveau d'écrêtage en fonction d'un niveau d'écrêtage prédit dans le signal audio après le traitement par les moyens de réduction ;
dans lequel les moyens de réduction sont configurés pour réduire les amplitudes des composantes de fréquence ayant la plus grande amplitude jusqu'à ce que les premier et deuxième niveaux d'écrêtage s'abaissent au-dessous d'un niveau prédéterminé.

8. Processeur de signaux numériques comprenant le circuit de la revendication 7.

9. Appareil audio comprenant le circuit de la revendication 7.

10. Logiciel destiné à configurer un matériel de manière à former le circuit de la revendication 7.
